# EUROPÄISCHE PATENTSCHRIFT

(11) **EP 1 196 912 B1**
(45) Veröffentlichungstag und Bekanntmachung des Hinweises auf die Patenterteilung: **24.03.2004**
(21) Anmeldenummer: 00958127.3
(22) Anmeldetag: 14.07.2000
(51) Int. Cl.: G10L 19/00, H04L 1/00

(54) **VERFAHREN UND VORRICHTUNG ZUR DECODIERUNG VON QUELLENSIGNALEN**
METHOD AND DEVICE FOR DECODING SOURCE SIGNALS
PROCEDE ET DISPOSITIF DE DECODAGE DE SIGNAUX DE SOURCE

(30) Priorität: 14.07.1999 DE 19932943
(43) Veröffentlichungstag der Anmeldung: 17.04.2002
(73) Patentinhaber: SIEMENS AKTIENGESELLSCHAFT, 80333 München (DE)
(72) Erfinder: HEINEN, Stefan, D-52349 Düren (DE); XU, Wen, D-82008 Unterhaching (DE)
(86) Internationale Anmeldenummer: PCT/DE2000/002303
(87) Internationale Veröffentlichungsnummer: WO 2001/004877

(56) Entgegenhaltungen:
- EP-A- 0 876 022
- WO-A-96/27183
- WO-A-99/63520
- US-A- 5 502 713
- T FINGSCHEIDT UND P VARY: "Error Concealment by Softbit Speech Decoding" ITG-FACHTAGUNG SPRACHKOMMUNIKATION, 17. September 1996 (1996-09-17), XP002075522 in der Anmeldung erwähnt

## Beschreibung

Die Erfindung betrifft ein Verfahren zur Decodierung von Quellensignalen, die codiert über einen Übertragungskanal gesendet wurden. Desweiteren betrifft die Erfindung eine entsprechende Vorrichtung zur Decodierung der Quellensignale. Unter Quellensignalen sind beispielsweise Sprach-, Audio- oder Videosignale zu verstehen. Im folgenden wird weitgehend von Sprachsignalen ausgegangen. Die Sprachsignale sind hierbei aber lediglich als Beispiel zu verstehen. Hiermit ist keinerlei Einschränkung der Erfindung in dieser Hinsicht verbunden.

Derartige Verfahren und Vorrichtungen werden derzeit üblicherweise bei der Sprachübermittlung in Mobilfunknetzen eingesetzt. Mobilfunknetze sind in der Regel so aufgebaut, daß in einem vorgegebenen Abstand zueinander mehrere Empfänger bzw. Empfänger/Sender-Stationen, sogenannte "base transceiver stations" (im folgenden auch BTS), möglichst flächendeckend angeordnet sind, so daß sich die Empfangsbereiche dieser BTS überlappen. Mehrere dieser BTS sind üblicherweise mit einem gemeinsamen sogenannten "base station controller" (im folgenden auch BSC) über Kabel verbunden, wobei der Abstand zwischen den BTS und der BSC in der Regel mehrere Kilometer beträgt. Diese BSC sind dann in der Regel wiederum an eine Mobilfunkvermittlungsstelle, das sogenannte "mobile switching center" (im folgenden auch MSC), angeschlossen, welche unter anderem für die Rufleitung, die Rufkontrolle sowie für die Zusammenarbeit mit anderen Netzen, beispielsweise normalen Festnetzen oder ISDN, zuständig ist.

Für die Übermittlung über eine Funkstrecke werden die Sprachsignale zunächst in einem Quellenencoder, hier einem Sprachencoder, in zeitliche Sprachabschnitte zerlegt, die durch verschiedene sogenannte Sprachparameter beschrieben werden können. Diese reellwertigen Sprachparameter werden dann quantisiert. Ein so quantisierter Parameter entspricht einem Eintrag in einer Quantisierungstabelle bzw. einem Codebuch, wobei der Parameter durch eine bestimmte Bitkombination repräsentiert wird. Der auf diese Weise digital codierte Sprachparameter wird anschließend weitergeleitet. Bei anderen Quellensignalen findet in ähnlicher Form eine Zerlegung in sogenannte quellencodierte Parameter oder auch quellencodierte Koeffizienten statt, die dann weitergeleitet werden.

Da bei der Übertragung der Parameter über einen Mobilfunkkanal mit Störungen und Verlusten zu rechnen ist, werden diesen codierten Signalen in einem Kanalencoder weitere, redundante Informationen hinzugefügt, aus denen auf der Empfängerseite Schlüsse über die Korrektheit des empfangenen Signals gezogen werden können.

Die über den Funkkanal empfangenen Daten werden dann in einem entsprechenden Kanaldecodierer zunächst vordecodiert, wobei alle die Daten, die nur für die Übertragung auf dem Funkkanal nötig waren, wieder absepariert werden. Hierzu zählen unter anderem die genannten redundanten Informationen, die Aussagen über die Übertragungsqualität enthalten. Dieser Kanaldecodierer befindet sich in der Regel am Ort der BTS.
Die Sprachparameter werden schließlich zur endgültigen Decodierung an einen Quellendecoder (bzw. Sprachdecoder) weitergeleitet. Dieser Quellendecoder ist üblicherweise Bestandteil einer sogenannten TRAU (Transcoder/Rate Adapter Unit) die von der BTS räumlich getrennt, typischerweise bei der BSC oder der MSC, angeordnet ist. Auf diese Weise wird die Datenrate zwischen den BTS und der BSC bzw. der MSC gering gehalten, wodurch unter anderem die Übertragungskosten reduziert werden können.

Bei der Übertragung der Sprachdaten über einen stark gestörten Funkkanal, können trotz Fehlerkorrektur im Zuge der Kanaldecodierung noch Restbitfehler im Bitstrom verbleiben. Eine Sprachdecodierung auf Basis dieser gestörten Sprachparameter würde im allgemeinen zu deutlichen Verzerrungen des Ausgangssprachsignals führen. Daher sind zusätzliche Fehlerverdeckungsmaßnahmen notwendig, um die subjektiv empfundene Wiedergabequalität zu verbessern, wobei sinnvollerweise die vom Kanaldecodierer ermittelten Informationen über die jeweilige Übertragungsqualität bzw. die Zuverlässigkeit der decodierten Bits genutzt werden.

Bei dem bisher bestehenden GSM-Standard wird in der Kanaldecodierung für jeden Sprachrahmen, das heißt für jede empfangene Bitfolge, eine kanalabhängige Zuverlässigkeitsinformation, ein sogenanntes BFI-Flag (bad frame indication), erzeugt. Hierzu wird vom Kanaldecoder ein CRC (Cyclic Redundancy Check) durchgeführt, der über die auditiv wichtigsten, das heißt störempfindlichsten Bits der Sprachparameterindizes gebildet wird. Das Ergebnis dieses Checks ist eine binäre Entscheidung (BFI=0, guter Rahmen; BFI=1, schlechter Rahmen), die nur 1 Bit benötigt. Dieses Flag wird an den Sprachdecoder weitergeleitet und.fließt dort in die Decodierung ein, indem bei einem als schlecht gekennzeichneten Rahmen die Werte des letzten guten Rahmens unmittelbar oder leicht modifiziert, beispielsweise abgeschwächt, wiederholt werden. Beim Aufeinanderfolgen mehrerer schlechter Rahmen erfolgt eine Stummschaltung, wodurch bei starken Kanalstörungen unter Umständen so viele Signalanteile abgeschnitten werden, daß die Verständlichkeit deutlich beeinträchtigt wird.

Ein Beispiel für ein bekanntes Verfahren zur Kanal- und Quellen codierung von Sprachsignalen wird in US-A-5 502 713 offenbart.

Von T. Fingscheidt und P. Vary wurde in dem Artikel "Error Concealment by Softbit Speech Decoding", in Proc. of ITG-Fachtagung Sprachkommunikation, S. 7 - 10, Frankfurt am Main, September 1996, ein völlig neues Fehlerverdeckungsverfahren vorgeschlagen. Bei diesem Verfahren wird die von dem Kanaldecoder ermittelte kanalabhängige Zuverlässigkeitsinformation dazu genutzt, um zu berechnen, mit welcher Wahrscheinlichkeit ein bestimmter Sprachparameter gesendet wurde, bzw. dazu, um einen Schätzwert des Sprachparameters so zu bestimmen, so daß dieser möglichst gut mit dem tatsächlich gesendeten Sprachparameter übereinstimmt. Im einzelnen wird hierbei für jede potentiell gesendete Bitkombination berechnet, mit welcher Wahrscheinlichkeit diese Bitkombination auf die empfangene Bitkombination übergegangen sein kann. Die Zuverlässigkeitsinformation wird hierbei in Form von einzelnen Bitfehlerwahrscheinlichkeiten ermittelt, wobei zu jedem einzelnen Informationsbit genau eine Bitfehlerwahrscheinlichkeit gehört. Das Paar, bestehend aus dem Informationsbit selber und der zugehörigen Bitfehlerwahrscheinlichkeit, wird als sogenanntes "Softbit" bezeichnet. Diese Softbits müssen der Fehlerverdeckungseinrichtung zur Abschätzung des Sprachparameters zur Verfügung gestellt werden. Bei dieser Art der Fehlerverdeckung treten infolge der Schätzung andere reelwertige Parameterwerte (Zwischenwerte) auf, als in der sendeseitigen Quantisierungstabelle enthalten sind, so daß eine Codierung des geschätzten Parameterwertes mit Hilfe dieser Quantisierungstabelle nicht fehlerfrei möglich ist. Deshalb ist diese Einrichtung bislang üblicherweise direkt mit dem Sprachdecodierer verbunden, da dieser die geschätzten reellwertigen Parameterwerte ohne zusätzliche Verluste unmittelbar verarbeiten kann.

Dies führt jedoch zu Schwierigkeiten auf Seiten der Basisstation. Aus den obengenannten Gründen befindet sich der Kanaldecodierer, welcher die Zuverlässigkeitsinformationen aus den übertragenden Signalen gewinnt, am Ort der Empfängerstation (BTS), der Sprachdecodierer jedoch an der TRAU, wobei die Übertragungsrate auf der dazwischenliegenden Verbindung begrenzt ist. Bei dem derzeitigen GSM-Standard liegt die Begrenzung bei 16 bzw. 8 kbit/s (fullrate bzw. halfrate), was dem sogenannten 16 bzw. 8 sub-multiplexing entspricht. Wenn bei einer Fehlerverdeckung nach dem zuletzt beschriebenen Verfahren jedoch ein Softbit durch beispielsweise 4 Bit repräsentiert wird, würde dies bei Verwendung der nach dem GSM-Standard üblichen 12,2 kbit/s-Sprachcodierern bzw. -decodierern insgesamt 12,2 x 4 = 48,8 kbit/s Datenstrom bedeuten. Eine Übertragung über eine Datenleitung, welche auf 16 kbit/s beschränkt ist, ist daher nicht möglich.

Die Aufgabe der vorliegenden Erfindung besteht darin, eine Alternative zu diesem Stand der Technik zu schaffen.

Diese Aufgabe wird durch ein Verfahren mit den Merkmalen gemäß Patentanspruch 1 bzw. durch eine Vorrichtung mit den Merkmalen nach Anspruch 9 gelöst.

Entscheidend bei dem neuen Verfahren bzw. der neuen Vorrichtung ist die erfindungsgemäße Entkopplung der Fehlerverdeckung von der eigentlichen Quellendecodierung. Durch die Durchführung der Fehlerverdeckung am Ort der Kanaldecodierung, bzw. des Empfängers müssen neben den quellencodierten Parametern keine zusätzlichen Kanalzustandsinformationen mehr an den Quellendecodierer weitergeleitet werden, so daß der Datenstrom erheblich reduziert werden kann. Es ist daher auch bei den bestehenden Anlagen und mit den bisherigen Standards möglich, ein verbessertes Fehlerverdeckungsverfahren durchzuführen, welches die kanal abhängigen Zuverlässigkeitsinformationen effektiver nutzt.

Die im Fehlerverdeckungsverfahren geschätzten quellencodierten Parameter können prinzipiell auf beliebige Weise an den Quellendekodierer weitergeleitet werden. Vorzugsweise werden sie jedoch wie die übermittelten quellencodierten Parameter quantisiert und in der bekannten digitalen Form an den Quellendekodierer weitergeleitet, um die übertragenen Datenströme zu minimieren. Bei entsprechend geeignet gewählter Quantisierung hat sich herausgestellt, daß durch diese erneute Quantisierung, im folgenden Requantisierung genannt, keinerlei zusätzliche Verluste oder Störungen auftreten.

Insbesondere hat es sich herausgestellt, daß es vorteilhaft ist, wenn zur Quantisierung der geschätzten quellencodierten Parameter mindestens die gleichen Quantisierungsstufen verwendet werden, wie für die Quantisierung der ursprünglich gesendeten quellencodierten Parameter. Bei einer fehlerfreien Übertragung wird so automatisch exakt der gesendete quellencodierte Parameter reproduziert. Wäre dies nicht der Fall, so würden Fehler bei einer ungestörten Übertragung durch die Requantisierung auftreten können.

Verschiedene Untersuchungen und Simulationen haben gezeigt, daß es bei Verwendung von Quantisierern mit einer ausreichend hohen Quantisierungsrate R ausreicht, wenn für die Requantisierung der geschätzten Parameter exakt der gleiche Quantisierer eingesetzt wird, wie auf der Sendeseite. Bei gaußverteilten Parametern ist dies bei senderseitigen Quantisierern mit R > 1 Bit/Abtastwert in der Regel möglich. Das Kriterium der Gaußverteilung wird dabei von den meisten der übertragenen quellencodierten Parametern in der Regel annäherungsweise recht gut erfüllt. Es kann daher als Quantisierungscodebuch für den geschätzten Parameter das sendeseitig verwendete Codebuch eingesetzt werden.

Wird auf der Sendeseite ein Quantisierer mit einer Rate von R ≤ 1 Bit/Abtastwert verwendet, kann ein Einfluß durch die Quantisierung der geschätzten Parameter dadurch gemindert werden, daß an dieser Stelle ein modifizierter Quantisierer mit einer höheren Rate eingesetzt wird. Das heißt, es wird ein Quantisierer gewählt, der zusätzlich zu den Quantisierungsstufen, die auf der Sendeseite zur Verfügung stehen, weitere Quantisierungsstufen verwendet. Bei Verwendung eines Quantisierers auf der Sendeseite mit nur R = 1 Bit/Abtastwert ist beispielsweise der Einsatz eines Quantisierers mit R = 2 Bit/Abtastwert zur Quantisierung der geschätzten Parameter empfehlenswert. Hierdurch lassen sich auf einfache Weise auch in solchen Fällen zusätzliche Störungen durch die Requantisierung auf der Empfängerseite recht gut vermeiden.

Im Rahmen der Weiterentwicklung des Mobilfunkstandards GSM wurde inzwischen ein neuer Standard für die codierte Sprachübertragung entwickelt. Hierbei handelt es sich um Codierer bzw. Decodierer (Codec's), die eine an den Kanalzustand und an die Systemlast angepaßte Aufteilung der zur Verfügung stehenden Gesamtdatenrate erlauben (adaptive multirate codec's; AMR-codec's). Es wird dabei einerseits der Kanalmodus (fullrate 22.8 kbit/s oder halfrate 11.4 kbit/s) festgelegt, andererseits wird die Quellen- und Kanalcodierung an die danach zur Verfügung stehende Datenrate angepaßt. Das heißt, daß während einer Übertragung in Abhängigkeit von der Übertragungsqualität des Kanals und der Anzahl der Benutzer, die diesen Kanal gleichzeitig belegen, die Codierrate geändert wird. Dementsprechend wird auch die Anzahl der Quantisierungsstufen bei der Codierung geändert. Es ist daher vorteilhaft, wenn auch die Quantisierung der im Fehlerverdeckungsverfahren geschätzten quellencodierten Parameter in Abhängigkeit von der aktuellen Codierrate des Senders erfolgt. Hierzu wird vorzugsweise ein Quantisierer gewählt, der sich an die unterschiedlichen Codierraten des Senders anpaßt.

Die Erfindung wird im folgenden unter Hinweis auf die beigefügten Zeichnungen anhand eines Ausführungsbeispiels näher erläutert. Es zeigen:
Figur 1 eine schematische Darstellung der Lage und Verbindungen der Empfänger (BTS), der BSC und der Mobilfunkvermittlungsstation (MSC) zueinander,
Figur 2 eine schematische Darstellung des Signalwegs durch die einzelnen Codierer und Decodierer.

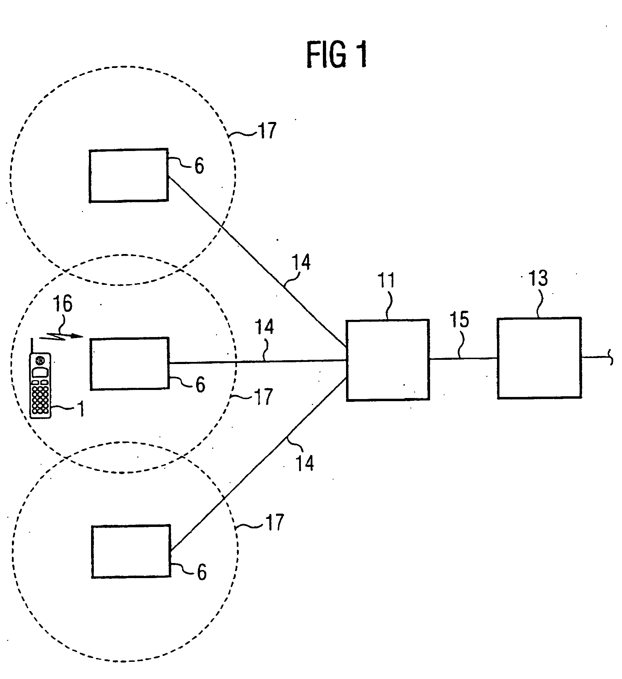

Wie Figur 1 vereinfacht zeigt, besteht eine heutzutage übliche, nach dem GSM-Mobilfunkstandard betriebene Basisstation aus einer BSC 11, an die mehrere BTS 6 über Datenleitungen 14 angeschlossen sind. Die BSC 11 ist wiederum über eine Datenleitung 15 mit einer MSC 13 verbunden. Eine MSC 13 bedient in der Regel mehrere BSC 11, was in der Figur 1 aus Platzgründen nicht dargestellt ist.

Die BTS 6 sind so voneinander beabstandet aufgestellt, daß sich ihre Empfangsbereiche 17 gerade überlappen, so daß eine möglichst flächendeckende Versorgung mit BTS 6 gegeben ist. Befindet sich nun ein Mobiltelefon 1 im Empfangsbereich einer BTS 6, so kann es mit dieser BTS 6 über eine Funkstrecke 17 kommunizieren. Wenn ein aktives Mobiltelefon 1 den Empfangsbereich 17 eines BTS 6 verläßt und in den Empfangsbereich 17 eines anderen BTS 6 der gleichen Basisstation eintritt, so wird dieses automatisch von der zugehörigen BSC 11 erkannt und es findet eine Übergabe von der einen BTS 6 zur nächsten statt (sogenanntes "handover"). Bei einem Übergang von dem Bereich einer Basisstation in eine andere Basisstation findet der "handover"-Prozeß mit Hilfe der MSC 13 statt; das heißt, das Gespräch wird automatisch an die neue Basisstation mit der anderen BSC 11 übergeben.

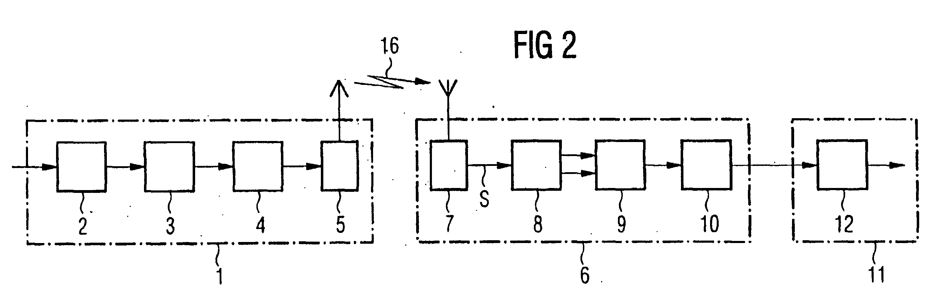

Der genaue Verlauf eines Sprachsignals vom Mobiltelefon 1 zur BSC 11, insbesondere die unterschiedlichen Codier- und Decodierstufen, sind aus der vereinfachten schematischen Darstellung Figur 2 zu ersehen. Hierbei ist nur der Signalaustausch in eine Richtung dargestellt. Üblicherweise handelt es sich bei den Codierern bzw. Decodierern jeweils um Codec's, das heißt kombinierte Codier-/Decodier-Einrichtungen, und bei den Sende- bzw. Empfangseinheiten um kombinierte Sende/Empfangseinheiten (transceiver).

Wie in Figur 2 dargestellt, wird das Sprachsignal zunächst durch einen Sprachcodierer 2 geleitet, in welchem die Sprache in einzelne Sprachparameter zerlegt wird. Jeder Laut wird hierbei durch eine bestimmte Anzahl von Sprachparametern repräsentiert. Typische Sprachparameter sind in einer Darstellung der Sprachsignale beispielsweise der "LPC-Koeffizient", der "LTP-Index", das "LTP-Gain" sowie die "Codebook-Indizes" und das "Codebook-Gain" bzw. in einer anderen Darstellung.das "LSP-Set", das "Pitch-Delay", der "Pitch-Gain", der "Algebraic-Code" und das "Codebook-Gain".

Diese Sprachparameter werden anschließend durch einen Quantisierer 3 geleitet und dort in eine Bitkombination umgewandelt, das heißt ein reellwertiger Sprachparameter v wird nach der Quantisierung durch die Bitkombination X repräsentiert. Je nach Übertragungsrate stehen für die einzelnen Parameter unterschiedlich viele Bits zur Codierung zur Verfügung. Beim AMR-Standard stehen insgesamt zur Sprachübertragung acht verschiedene Übertragungsmoden mit Datenraten zwischen 12.2 kbit/s und 4.75 kbit/s zur Wahl.

Vom Quantisierer 3 werden die Sprachparameter v in der digitalen Darstellung X an einen Kanalcodierer 4 übermittelt, welcher den Daten die für die Übertragung benötigten Kanalinformationen hinzufügt. Dies sind unter anderem redundante Daten, die es dem Empfänger ermöglichen, die Richtigkeit der empfangenen Daten zu prüfen und ggf. Übertragungsfehler zu korrigieren. Von einer Sendeeinheit 5 bzw. einem Transceiver werden dann über einen Funkkanal 16 die Funksignale an ein Empfangselement 7, beispielsweise eine Antenne mit einem Demodulator und/oder Entzerrer, der BTS 6 gesendet.

In der BTS 6 gelangen die empfangenen Signale S zunächst in einen Kanaldecodierer 8, welcher die empfangenen Signale S vordecodiert. Bei der Vordecodierung werden aus den Signalen S Zuverlässigkeitsinformationen gewonnen, die mit der Übertragungsqualität korreliert sind. Hierbei kann es sich beispielsweise um Ergebnisse aus Paritäts-Checks handeln.

Diese zusätzlich gewonnenen Informationen über den Kanalzustand werden gemeinsam mit den im Kanaldecodierer 8 ermittelten, empfangenen Sprachparametern an eine Fehlerverdeckungseinrichtung 9 übermittelt. Dies wird in Figur 2 durch zwei Pfeile zwischen dem Kanaldecoder 8 und der Fehlerverdeckungseinrichtung 9 verdeutlicht. Am Ausgang des Kanaldecoders 8 liegt der über den Funkkanal empfangene Sprachparameter noch in digital codierter Form vor, das heißt er wird durch eine Bitkombination X' dargestellt, welche bei einer fehlerfreien Übertragung mit der gesendeten Bitkombination X übereinstimmt.

Die Fehlerverdeckungseinrichtung 9 arbeitet im vorliegenden Ausführungsbeispiel nach dem im Stand der Technik genannten Fehlerverdeckungsverfahren von T. Fingscheidt und P. Vary. Bei diesen Verfahren wird mit Hilfe der Zuverlässigkeitsinformationen zunächst für jedes einzelne Bit der Kombination X' ermittelt, mit welcher Wahrscheinlichkeit es fehlerhaft übertragen wurde. Diese Wahrscheinlichkeit ist alleine vom Zustand des Kanals abhängig. Zusätzlich können in dem Fehlerverdeckungsverfahren Informationen eingebracht werden, die von der ursprünglichen Quelle des empfangenen Signals abhängen. Hierbei handelt es sich beispielsweise um Wahrscheinlichkeiten, mit denen ein bestimmter Parameter und somit eine bestimmte Bitkombination sendeseitig auftreten kann. Diese Auftrittswahrscheinlichkeiten können im vorhinein mit Hilfe einer repräsentativen Sprachdatenbasis bestimmt werden und in Tabellen abgelegt sein. Weiterhin könnte berücksichtigt werden, mit welcher Wahrscheinlichkeit zwei bestimmte Parameter bzw. Bitkombinationen direkt aufeinanderfolgen, um so Korrelationen zwischen aufeinanderfolgenden empfangenen Sprachrahmen mitzuberücksichtigen.

Aus den genannten Einzelwahrscheinlichkeiten, die entweder kanal- oder quellenabhängig sind, wird dann entweder ein Parameter v̂ abgeschätzt, der mit größter Wahrscheinlichkeit dem ursprünglich gesendeten Sprachparameter v entspricht (maximum-a-posteriori-Schätzung), oder es wird eine Schätzung durchgeführt, bei der der mittlere quadratische Fehler der möglichen Abweichungen des geschätzten Parameters v̂ vom gesendeten Parameter v minimal ist (mean-square-Schätzung).

Der von der Fehlerverdeckungseinrichtung 9 geschätzte reellwertige Parameter v̂ wird dann vor der Übermittlung an den an der BSC 11 angeordneten Sprachdecoder 12 erneut durch einen Quantisierer 10 geleitet, welcher in gleicher Weise wie der Quantisierer 3 auf der Sendeseite arbeitet und den reellwertigen Parameter v̂ in eine digitale Bitkombination X̂ umwandelt. Anstelle der von dem Kanaldecoder ermittelten Bitkombination X' für den empfangenen Parameter erhält folglich der Sprachdecoder 12 nun eine in der gleichen Weise codierte Bitkombination X̂, welche den von der Fehlerverdeckung abgeschätzten Sprachparameter v̂ repräsentiert, der mit größter Wahrscheinlichkeit mit dem gesendeten Sprachparameter v übereinstimmt, bzw. mit dem geringsten Fehler davon abweicht.

Bei dem Quantisierer 10 in der BTS 6 handelt es sich im vorliegenden Ausführungsbeispiel um das exakt gleiche Modell wie bei dem Quantisierer 3 im Mobiltelefon 1. Es handelt sich hierbei um übliche Codec's, beispielsweise AMR-oder FR(Full Rate)-Codec's im GSM-Standard. Dem Quantisierer 10 stehen auch die gleichen Codebücher zur Verfügung wie dem Quantisierer 3.

Es wird noch einmal darauf hingewiesen, daß die Erfindung nicht auf das dargestellte konkrete Ausführungsbeispiel beschränkt ist. So ist prinzipiell auch ein Einsatz in Anlagen möglich, die nicht nach dem GSM-Standard, sondern beispielsweise nach neueren, derzeit noch in der Entwicklung befindlichen Standards, wie dem UMTS-Standard, arbeiten. Ebenso muß sich der Quellendecodierer 12 nicht zwingend in der BSC 11 befinden, sondern kann als eigenständige Einheit, alleine oder mit anderen Funktionseinheiten kombiniert, beispielsweise in Form der sogenannten TRAU, vor oder hinter der BSC angeordnet sein. Insbesondere kann anstelle des Verfahrens nach Fingscheidt und Vary auch ein anderes Fehlerverdeckungsverfahren verwendet werden, das mit Hilfe der Zuverlässigkeitsinformationen den gesendeten quellencodierten Parameter schätzt, das heißt den empfangenen Parameter mit Hilfe der Zuverlässigkeitsinformation so korrigiert, daß er dem vermutlich richtigen gesendeten Parameter entspricht. Des weiteren ist, wie bereits oben erwähnt, die Erfindung nicht auf Sprachsignale beschränkt, sondern kann auch bei beliebigen anderen Quellensignalen eingesetzt werden.

Mit dem erfindungsgemäßen Verfahren bzw. der Vorrichtung wird auch bei sehr schlechten Funkkanälen eine verbesserte Übertragungsqualität erzielt, da die vom Kanaldecodierer erhaltenen kanalabhängigen Zuverlässigkeitsinformationen sowie die quellenabhängigen Informationen erheblich besser ausgenutzt werden, um auftretende Fehler zu eliminieren. Durch die spezielle räumliche Anordnung der Fehlerverdeckungseinrichtung sowie den nachgeschalteten Quantisierer kann dies ohne eine Erhöhung der Datenrate zwischen dem Kanaldecodierer und dem Quellendekodierer erfolgen.

## Patentansprüche

1. Verfahren zur Decodierung von Quellensignalen,
bei dem zunächst die empfangenen Signale (S) in einem Kanaldecodierer (8) vordecodiert werden und dabei aus den empfangenen Signalen (S) quellencodierte Parameter ermittelt werden, die an einen räumlich von dem Kanaldecodierer (8) getrennten Quellendecodierer (12) weitergeleitet und dort weiterdecodiert werden,
wobei bei der Vordecodierung aus den empfangenen Signalen (S) Zuverlässigkeitsinformationen gewonnen werden, die mit der Übertragungsqualität korreliert sind,
und wobei mit Hilfe dieser Zuverlässigkeitsinformationen in einem Fehlerverdeckungsverfahren aus den empfangenen quellencodierten Parametern die gesendeten quellencodierten Parameter geschätzt werden,
**dadurch gekennzeichnet, daß** die Fehlerverdeckung am Ort des Kanaldecodierers (8) durchgeführt wird und die geschätzten quellencodierten Parameter an den Quellendecodierer (12) weitergeleitet werden.

2. Verfahren nach Anspruch 1, **dadurch gekennzeichnet, daß** die geschätzten quellencodierten Parameter zur Weiterleitung an den Quellendecodierer (12) quantisiert werden.

3. Verfahren nach Anspruch 1 oder 2, **dadurch gekennzeichnet, daß** zur Quantisierung der geschätzten quellencodierten Parameter mindestens die gleichen Quantisierungsstufen verwendet werden, wie für die Quantisierung der gesendeten quellencodierten Parameter.

4. Verfahren nach einem der Ansprüche 1 bis 3, **dadurch gekennzeichnet, daß** zur Quantisierung der geschätzten quellencodierten Parameter zusätzlich zu den Quantisierungsstufen, die für die Quantisierung der gesendeten quellencodierten Parameter verwendet werden, weitere Quantisierungsstufen verwendet werden.

5. Verfahren nach einem der Ansprüche 1 bis 4, **dadurch gekennzeichnet, daß** die Quantisierung der geschätzten quellencodierten Parameter in Abhängigkeit von der aktuellen Codierrate des Senders (1) erfolgt.

6. Verfahren nach einem der Ansprüche 1 bis 5, **dadurch gekennzeichnet, daß** mit Hilfe des empfangenen Parameters und der Zuverlässigkeitsinformationen empfangsseitig für mindestens einen der sendeseitig möglichen quellencodierten Parameter ermittelt wird, mit welcher Wahrscheinlichkeit dieser tatsächlich gesendet wurde, und dann unter Berücksichtigung dieser Wahrscheinlichkeiten die gesendeten quellencodierten Parameter geschätzt werden.

7. Verfahren nach einem der Ansprüche 1 bis 6, **dadurch gekennzeichnet, daß** ein quellencodierter Parameter in Form einer Bitkombinationen codiert ist und für jedes Bit eine zugehörige Bitfehlerwahrscheinlichkeit ermittelt wird, mit deren Hilfe der gesendete quellencodierte Parameter geschätzt und anschließend der geschätzte quellencodierte Parameter quantisiert und in Form einer entsprechenden Bitkombination weitergeleitet wird.

8. Verfahren nach einem der Ansprüche 1 bis 7, **dadurch gekennzeichnet, daß** die quellencodierten Parameter entsprechend dem GSM-Standard codiert sind.

9. Vorrichtung zur Decodierung von codierten, über einen Übertragungskanal gesendeten Quellensignalen,
mit einem Kanaldecodierer (8), welcher die empfangenen Signale (S) vordecodiert und dabei aus den empfangenen Signalen (S) quellencodierte Parameter ermittelt und Zuverlässigkeitsinformationen gewinnt, die mit der Übertragungsqualität korreliert sind,
und mit einem räumlich von dem Kanaldecodierer (8) getrennt angeordneten Quellendecodierer (12), an den die quellencodierten Parameter weitergeleitet werden und der die quellencodierten Parameter weiterdecodiert,
und mit einer Fehlerverdeckungseinrichtung (9), welche unter Berücksichtigung der Zuverlässigkeitsinformationen aus den. empfangenen quellencodierten Parametern die gesendeten quellencodierten Parameter schätzt,
**dadurch gekennzeichnet, daß** die Fehlerverdeckungseinrichtung (9) am Ort des Kanaldecodierers (8) angeordnet ist, und die geschätzten quellencodierten Parameter an den Quellendecodierer (12) weitergeleitet werden.

10. Vorrichtung nach Anspruch 9, **gekennzeichnet durch** einen Quantisierer (10), der die geschätzten quellencodierten Parameter zur Weiterleitung den Quellendecodierer (12) quantisiert.

11. Vorrichtung nach Anspruch 9 oder 10, **dadurch gekennzeichnet, daß** der Quantisierer (10) mindestens die gleichen Quantisierungsstufen aufweist, wie ein Quantisierer (3) der auf der Sendeseite die quellencodierten Parameter vor dem Senden quantisiert.

12. Vorrichtung nach einem der Ansprüche 9 bis 11, **dadurch gekennzeichnet, daß** der Quantisierer (10) mehr Quantisierungsstufen aufweist, als der auf der Sendeseite befindliche Quantisierer (3).

13. Vorrichtung nach einem der Ansprüche 9 bis 12, **dadurch gekennzeichnet, daß** der Quantisierer (10) sich an unterschiedliche Codierraten des Senders (1) anpaßt.

14. Vorrichtung nach einem der Ansprüche 8 bis 13, **dadurch gekennzeichnet, daß** der Kanaldecodierer (8) an einer Basis-Transceiver-Station (BTS, base transceiver station) eines Mobilfunknetzes angeordnet ist.

15. Vorrichtung nach einem der Ansprüche 9 bis 14, **dadurch gekennzeichnet, daß** der Quantisierer (10) ein Standard-GSM-Quantisier ist.

## Claims

1. Method for decoding source signals, in which the received signals (S) are first of all initially decoded in a channel decoder (8) and, in the process, source-coded parameters are determined from the received signals (S) and are passed on to a source decoder (12), which is physically separated from the channel decoder (8), where they are further-decoded,
with reliability information, which is correlated with the transmission quality, being obtained from the received signals (S) during the initial decoding,
and with the transmitted source-coded parameters being estimated from the received source-coded parameters by means of this reliability information using an error concealment method,
**characterized in that** the error concealment is carried out at the same location as the channel decoder (8), and the estimated source-coded parameters are passed on to the source decoder (12).

2. Method according to Claim 1, **characterized in that** the estimated source-coded parameters are quantized for passing on to the source decoder (12).

3. Method according to Claim 1 or 2, **characterized in that** at least the same quantization steps as those used for the quantization of the transmitted source-coded parameters are used for quantization of the estimated source-coded parameters.

4. Method according to one of Claims 1 to 3, **characterized in that** further quantization steps are used for quantization of the estimated source-coded parameters, in addition to the quantization steps which are used for quantization of the transmitted source-coded parameters.

5. Method according to one of Claims 1 to 4, **characterized in that** the quantization of the estimated source-coded parameters is carried out as a function of the current coding rate of the transmitter (1).

6. Method according to one of Claims 1 to 5, **characterized in that** the received parameter and the reliability information are used at the receiving end, for at least one of the source-coded parameters which are possible at the transmission end, to determine the probability with which this has actually been transmitted, and the transmitted source-coded parameters are then estimated taking account of these probabilities.

7. Method according to one of Claims 1 to 6, **characterized in that** a source-coded parameter is coded in the form of a bit combination, and an associated bit error probability is determined for each bit, using which the transmitted source-coded parameter is estimated, and the estimated source-coded parameter is then quantized and is passed on in the form of a corresponding bit combination.

8. Method according to one of Claims 1 to 7, **characterized in that** the source-coded parameters are coded in accordance with the GSM Standard.

9. Apparatus for decoding coded source signals which are transmitted via a transmission channel,
having a channel decoder (8) which initially decodes the received signals (S) and in the process determines source-coded parameters from the received signals (S) and obtains reliability information, which is correlated with the transmission quality, and having a source decoder (12) which is arranged physically separately from the channel decoder (8), and to which the source-coded parameters are passed on and which further-decodes the source-coded parameters,
and having an error concealment device (9), which estimates the transmitted source-coded parameters from the received source-coded parameters, taking account of the reliability information,
**characterized in that** the error concealment device (9) is arranged at the same location as the channel decoder (8), and the estimated source-coded parameters are passed on to the source decoder (12).

10. Apparatus according to Claim 9, **characterized by** a quantizer (10), which quantizes the estimated source-coded parameters for passing them on to the source decoder (12).

11. Apparatus according to Claim 9 or 10, **characterized in that** the quantizer (10) has at least the same quantization steps as a quantizer (3) which quantizes the source-coded parameters, before transmission, at the transmission end.

12. Apparatus according to one of Claims 9 to 11, **characterized in that** the quantizer (10) has more quantization steps than the quantizer (3) located at the transmission end.

13. Apparatus according to one of Claims 9 to 12, **characterized in that** the quantizer (10) is matched to different coding rates of the transmitter (1).

14. Apparatus according to one of Claims 8 to 13, **characterized in that** the channel decoder (8) is arranged at a base transceiver station (BTS) in a mobile radio network.

15. Apparatus according to one of Claims 9 to 14, **characterized in that** the quantizer (10) is a standard GSM quantizer.

## Revendications

1. Procédé pour le décodage de signaux sources, avec lequel on commence par prédécoder les signaux (S) reçus dans un décodeur de canal (8) et, à partir des signaux (S) reçus, on détermine des paramètres codés au niveau de la source qui sont acheminés à un décodeur de source (12) séparé dans l'espace du décodeur de canal (8) et y sont à nouveau décodés,
des informations de fiabilité qui sont en corrélation avec la qualité de transmission étant obtenues lors du prédécodage à partir des signaux (S) reçus,
et les paramètres codés au niveau de la source et envoyés étant évalués à l'aide de ces informations de fiabilité dans une procédure de masquage d'erreurs à partir des paramètres codés au niveau de la source et reçus,
**caractérisé en ce que** le masquage d'erreurs est effectué à l'emplacement du décodeur de canal (8) et les paramètres codés au niveau de la source et évalués sont acheminés au décodeur de source (12).

2. Procédé selon la revendication 1, **caractérisé en ce que** les paramètres codés au niveau de la source et évalués sont quantifiés pour la transmission au décodeur de source (12).

3. Procédé selon la revendication 1 ou 2, **caractérisé en ce que**, pour la quantification des paramètres codés au niveau de la source et évalués, on utilise au moins les mêmes niveaux de quantification que pour la quantification des paramètres codés au niveau de la source et envoyés.

4. Procédé selon l'une quelconque des revendications 1 à 3, **caractérisé en ce que**, pour la quantification des paramètres codés au niveau de la source et évalués, on utilise d'autres niveaux de quantification en supplément des niveaux de quantification qui sont utilisés pour la quantification des paramètres codés au niveau de la source et envoyés.

5. Procédé selon l'une quelconque des revendications 1 à 4, **caractérisé en ce que** la quantification des paramètres codés au niveau de la source et évalués s'effectue en fonction du débit de codage actuel de l'émetteur (1).

6. Procédé selon l'une quelconque des revendications 1 à 5, **caractérisé en ce que**, à l'aide du paramètre reçu et des informations de fiabilité, on détermine côté réception pour au moins un paramètre codé au niveau de la source et possible côté émission avec quelle probabilité ce paramètre a été envoyé réellement et les paramètres codés au niveau de la source et envoyés sont évalués alors compte tenu de ces probabilités.

7. Procédé selon l'une quelconque des revendications 1 à 6, **caractérisé en ce qu'**un paramètre codé au niveau de la source est codé sous la forme d'une combinaison de bits et on détermine pour chaque bit une probabilité d'erreur de bit spécifique à l'aide de laquelle on évalue le paramètre codé au niveau de la source et envoyé et on quantifie ensuite le paramètre codé au niveau de la source et évalué et on l'achemine sous la forme d'une combinaison de bits appropriée.

8. Procédé selon l'une quelconque des revendications 1 à 7, **caractérisé en ce que** les paramètres codés au niveau de la source sont codés en fonction du standard GSM.

9. Dispositif pour le décodage de signaux sources codés et envoyés par un canal de transmission, avec un décodeur de canal (8) qui précode des signaux (S) reçus et détermine alors des paramètres codés au niveau de la source à partir des signaux (S) reçus et obtient des informations de fiabilité qui sont en corrélation avec la qualité de transmission, et avec un décodeur de source (12) disposé dans l'espace séparément du décodeur de canal (8), auquel les paramètres codés au niveau de la source sont acheminés et qui redécode les paramètres codés au niveau de la source, et avec un dispositif de masquage d'erreurs (9) qui évalue les paramètres codés au niveau de la source et envoyés à partir des paramètres codés au niveau de la source et reçus compte tenu des informations de fiabilité,
**caractérisé en ce que** le dispositif de masquage d'erreurs (9) est disposé à l'emplacement du décodeur de canal (8), et les paramètres codés au niveau de la source et évalués sont acheminés au décodeur de source (12).

10. Dispositif selon la revendication 9, **caractérisé par** un quantificateur (10), qui quantifie les paramètres codés au niveau de la source et évalués pour la transmission au décodeur de source (12).

11. Dispositif selon la revendication 9 ou 10, **caractérisé en ce que** le quantificateur (10) présente au moins les mêmes niveaux de quantification qu'un quantificateur (3) qui quantifie du côté émission les paramètres codés au niveau de la source avant l'émission.

12. Dispositif selon l'une quelconque des revendications 9 à 11, **caractérisé en ce que** le quantificateur (10) présente davantage de niveaux de quantification que le quantificateur (3) se trouvant du côté émission.

13. Dispositif selon l'une quelconque des revendications 9 à 12, **caractérisé en ce que** le quantificateur (10) s'adapte à différents débits de codage de l'émetteur (1).

14. Dispositif selon l'une quelconque des revendications 8 à 13, **caractérisé en ce que** le décodeur de canal (8) est disposé sur une station de récepteur-émetteur combiné de base (BTS, base transceiver station) d'un réseau de téléphonie mobile.

15. Dispositif selon l'une quelconque des revendications 9 à 14, **caractérisé en ce que** le quantificateur (10) est un quantificateur GSM standard.
